(19) Europäisches Patentamt
European Patent Office
Office européen des brevets

(11) **EP 2 949 908 B1**

## (12) EUROPEAN PATENT SPECIFICATION

(45) Date of publication and mention
of the grant of the patent:
**06.07.2016 Bulletin 2016/27**

(51) Int Cl.:
*F02D 41/24* *(2006.01)* *F02D 41/26* *(2006.01)*
*F02D 41/00* *(2006.01)* *F02D 35/02* *(2006.01)*

(21) Application number: **14170618.4**

(22) Date of filing: **30.05.2014**

(54) **Method for simulation of an internal combustion engine**

Verfahren zur Simulation einer Brennkraftmaschine

Procédé de simulation d'un moteur à combustion interne

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**02.12.2015 Bulletin 2015/49**

(73) Proprietor: **AVL List GmbH
8020 Graz (AT)**

(72) Inventor: **Katrasnik, Tomaz
2000 Maribor (SI)**

(74) Representative: **Patentanwälte Pinter & Weiss OG
Prinz-Eugen-Straße 70
1040 Wien (AT)**

(56) References cited:
**US-A- 5 771 482**     **US-A- 5 806 506**
**US-A1- 2011 083 642**

**Description**

The present invention relates to a method for simulation of an internal combustion engine comprising a number of cylinders, wherein simulation output parameters of the cylinders are calculated based on the angular position of a crank shaft. Further the present invention relates to a simulation equipment comprising means to perform the inventive method.

Due to the complexity of thermodynamic engine models, simulation has to be performed in a computationally efficient manner, even if the most powerful simulation equipment available at this time is being used. Computational efficiency and short computational times are very important in an early development stage as they enable efficient exploration of the vast space of possible solutions, whereas it is of utmost importance during real-time test on hardware-in-the-loop (HiL) simulators. Nonetheless the thermodynamic basis of the model requires solutions of the systems of differential equations in each component introducing a significant computational burden.

The term "HiL-Simulation" refers to a simulation environment, which comprises embedded hardware operating in real-time. To successfully run a HiL-Simulation, not only the simulation part has to be calculated faster than real time, but it also has to be faster in each and every sampling interval throughout the whole HiL-Simulation. This means that, for example, if the data exchange frequency is 1 kHz, each milisecond of the physical time of the model has to be calculated in less than 1 millisecond computational time. Some HiL simulators allow for a limited number of real-time violations, but this does not resolve the underlying problem.

Simulation tools can be characterized by the respective modeling approach that is used, e.g. simulation tools can be grouped into simulation tools using physical based modeling approaches and simulation tools using data driven modeling approaches.

The term "data driven modeling approach", as it is used within this specification, relates to simulation models that use a fixed input data set for the calculation of simulation parameters. Often measured data and data from previous tests are used and the data can be manipulated by mathematical methods to adapt them to a specific simulation model. One particular type of a data driven modeling approach is a map based model wherein model parameters are stored in maps. An engine related example for a data set that can be used by a map based modeling approach is the measured fuel consumption as a function of engine speed and torque. During the simulation the model instantaneously returns a value for the fuel consumption as a function of engine speed and required torque by interpolating between the measured/input points.

Also neural networks and support and relevance vector machines, which are often named "surrogates models", belong to the data driven modeling approaches. Some models require "training", which means that model parameters of, e.g. neural networks and support and relevance vector machines, are adjusted in such a way that the results of the data driven model matches input data as good as possible over the input/trained range of independent variables of the model.

The term "physical based modeling approach", as it is used within this specification, relates to simulation models, wherein processes in the components are modeled based on physical laws, rather than using measured or input data. Examples for physical based modeling approaches are dimensional modeling approaches, e.g. the so called 0D modeling approach and 1 D modeling approach. Physical based models might also include a limited number of phenomenological sub-models to model specific phenomena that cannot be resolved with physical models.

In a 0D simulation, which term denotes the execution of a model that relies on the "0D modeling approach", in each element (e.g. cylinder, intake or exhaust manifold) thermodynamic equations, e.g. equations for mass, energy and optionally species conservation, are solved as a function of time. As there is no spatial resolution the model is named 0D.

A 1 D modeling approach can generally be used to model wave propagation in the intake and exhaust manifolds and elements are therefore discretized in a series of volumes in one dimension. In addition to the equations of 0D models, momentum equations are solved enabling modeling of pressure wave propagations.

2D and 3D modeling approaches can be defined accordingly by adding further dimensions to the simulation model.

Higher dimensional modeling approaches, especially 2D or 3D modeling approaches, are currently not used for real time engine simulations, as the computational complexity rises exponentially with each dimension. In the context of real-time enabled engine simulation models even OD- and/or 1D-simulations can currently only be performed for rather simple models, e.g. comprising only one cylinder or reduced complexity of the intake or exhaust system topologies, and/or for lower or medium rotational speeds of the engine. Nonetheless it would be a great benefit if physical models could be used for real time simulation for engines featuring an arbitrary number of cylinders, arbitrary or complex intake or exhaust system topologies and/or turbo/super charging topologies and operating at high engine speeds.

It is an object of the invention to provide a simulation system and method which, amongst others, allows to make better use of the benefits of physical based models, for example: higher level of predictability of the model, higher accuracy of transient engine results, capability to adequately respond to changed parameters of the components or time dependent cylinder specific control strategies, capability to model all interactions between the components on the system level, inherent availability of in-cylinder pressure traces that can be used closed-loop-combustion-control and inherent availability of cycle resolved torque oscillations that can be used in NVH analyses.

The invention further aims at providing a simulation environment that is capable of performing physical based real time and particularly HiL capable simulations of multi-cylinder engines with complex intake and exhaust system topologies even at a high speed range of the engine.

With the aim to ensure timely exchange of the data through the I/O interface, EP2579115B1 or US2013090886A1 disclose a method for real time testing of a control unit for an internal combustion engine comprising an engine simulator, wherein at least some of the engine state variables are transmitted to the control unit with a first transmission step size, and at least one specific engine state variable of the engine state variables is transmitted with a second sampling step size that is different from the first sampling step size. It is also possible to ensure timely exchange of the data through the I/O interface by optimizing computational expenses of the model and thus increasing its computational speed.

WO2008078097A1 discloses a method for creating a simplified computer implementable engine model from a complete computer implementable engine model generated by a 1-dimensional gas dynamics simulation software package. The method at least partially relies on excluding complex elements that are not relevant to flow control model and merging small elements together.

Another approach of reducing computational expenses of the 0-dimensional engine models is presented in the non-patent document "Tailored cylinder models for system level engine modelling", Katrasnik, T. et al., 2012 IFAC Workshop on Engine and Powertrain Control, Simulation and Modeling 2012; 3(1):162-169. The model disclosed in this document relies on the time-domain decoupling, wherein the engine block domain, which is characterized by shorter characteristic time scales, is integrated with higher rate compared to the gas path domain, which is characterized by longer characteristic time scales.

All cited approaches calculate thermodynamic processes in all engine cylinders, which represent a significant computational burden when modeling multi-cylinder engines with large numbers of cylinders and/or engines with complex intake and exhaust system topologies and/or turbo/super charging topologies at high engine speeds and can consequently lead to the violation of the real-time constraints imposed by the HiL simulators as computational speed of the model is not sufficient to comply with the update frequency of the HiL simulator.

US 2011/083642 A1 is another relevant document which discloses an engine control approach based on calculation of combustion timing, the latter being based on cylinder pressure readings in at least one master cylinder. Based thereon, combustion in cylinders without pressure sensor is controlled. Based on the cylinder pressure detection, mass-fraction-burned (MFB) data is calculated. Start-of-combustion (SOC) data is derived, and MFB-50% feedback control of the master cylinder is performed. The SOC data of the master cylinder is used as reference data to establish a relationship between this data and vibration sensor data. Based on this relationship, slave cylinders can then be SOC-controlled using the vibration sensor data.

Known simulation equipment and methods are often not capable of complying with the constraints imposed by the HiL-Simulation, especially in the circumstances mentioned above. Therefore it is currently not possible to ensure that 0D or 1 D physical based models of modern automotive engines featuring characteristics listed in the previous sentence comply with constraints imposed by the HiL-Simulation. Consequently there still exists a need for methods and systems with improved simulation performance, especially in the field of physical based models for HiL-Simulations.

The present invention addresses these and other problems by providing a method for simulation of an internal combustion engine comprising a number of cylinders, wherein simulation output parameters of the cylinders are calculated based on the angular position of a crank shaft, wherein the method comprises the following steps:

- grouping the cylinders into a number of cylinder groups, wherein each cylinder group comprises a number of cylinders, with a minimum of one cylinder;

- designating one cylinder of each group as a master cylinder and all other cylinders in the same group as slave cylinders; and

- for each simulation timestep

  ∘ calculating simulation output parameters of the master cylinder for at least one crank-angle position in the respective simulation timestep by simulation of the master cylinder and storing the output parameters; and

  ∘ determining simulation output parameters of the slave cylinders at the current angular position of the respective slave cylinder by mapping of previous simulation output parameters, which were stored for the master cylinder at at least one previous simulation step of the master cylinder.

The method according to this embodiment significantly reduces computational expenses for the simulation of the engine, while it allows for achieving with high accuracy, especially during steady state operation.

The term "mapping", as it is used within this document, denotes any determination of simulation output parameters for one cylinder (i.e. the slave cylinder), that is done using values that where determined for a different cylinder (i.e. the master cylinder) at a corresponding angular position.

According to a preferred embodiment the intervals of the simulation timesteps are calculated in a time domain and intervals of the crank-angle positions are calculated in an angular domain. The steps of the time domain usually correspond to the simulation of the gas path and therefore this domain is also referred to as a "gas path domain". In the angular domain, the angular intervals depend on the angular position of the crank-shaft. The duration of one calculation step in the angular domain therefore depends on the rotational speed of the engine and can be significantly shorter than the duration of the simulation timesteps of the time domain. Either the length of the time steps and/or the length of the angular intervals can change during the simulation. For example the angular interval could be chosen so that an integer number of angular steps occurs within each time step of the time domain. The length of successive angular intervals could also change in a different manner.

According to a different embodiment, both domains can be calculated in a fully coupled manner using identical time steps in either time or crank-angle intervals.

According to a preferred embodiment the mapping can use linear interpolation between previous simulation output parameters stored at an angular interval.

To further provide for an improved accuracy in transient engine operation, the invention can additionally comprise the steps of:

- determining a correction factor for a simulation output parameter for the current angular position of the slave cylinder;

- applying the correction factor to a mapped simulation output parameter of the slave cylinder for the current angular position.

Applying the correction factor mitigates the problems that can arise from transient engine operation. Without the correction factor, all slave cylinders that are modeled as phasing images of the master cylinder would feature identical parameters to the master cylinder. Any variations of thermodynamic and control parameters of the engine that have occurred in the time frame between the simulation of the master cylinder at a specific crank-angle and the time the respective parameters are mapped to the slave cylinder that subsequently reaches the same crank-angle at a later time in the same cycle period, would not be considered. Therefore the accuracy of the simulation of the slave cylinders can further be improved by applying a correction factor.

In a further embodiment, a correction factor can be derived from a simulation or control input parameter, or calculated based on the changes of state variables. The correction factor can be derived from simulation or control input parameters, or calculated based on the changes of state variables, which have occurred in the time period that corresponds to the shift in firing angles between the master and slave cylinder, which defines the time delay of that particular slave cylinder. This embodiment permits an analytically based computation of correction factors with very low CPU demand. Correction factors can therefore be applied to the simulation output parameters of the slave cylinders to more adequately consider any changes that arise due to transient engine operation. This embodiment therefore combines computational efficiency arising from calculating reduced number of master cylinders and achieving high accuracy of transient results that arises from applying correction factors to the simulation output parameters of the slave cylinders.

In a still further embodiment, the simulation of the master cylinder can be performed based on a physical based modeling approach. The computational expenses of the physical based model depend on the performance of the available simulation equipment and the properties of the simulated engine (e.g.: number of cylinders, number of groups, topology of the intake and exhaust system and topology of turbo/super charging systems and simulated engine speed).

According to a further embodiment of the inventive method, the number of groups is one. Consequently the simulation only has to simulate thermodynamic equations in a single cylinder for the whole engine, which shortens computational time of the model.

According to a further embodiment of the inventive method, the number of groups is larger than one. This enables a simulation of an engine in operating conditions, where some of the cylinders are being run with different properties or control strategies than others, e.g. the engine can be simulated with groups of cylinders being deactivated. On the other hand the cylinders could be grouped according to their angular sequence, e.g. into a first group comprising the cylinders that reach the firing top dead center during the first half of the engine cycle, and a second group comprising the cylinders that reach the firing top dead center during the second half of the engine cycle, the master cylinder of the second group being phase delayed to the master cylinder of the first group for half of the engine cycle. This could reduce the effect of the time lag of the slave cylinders.

In a method according to a further embodiment, the cylinders of at least one group can be associated to a common intake and/or exhaust manifold and/or a common turbo/super charger and/or to a common control strategy.

Thus different manifold topologies, turbo/super charging systems and control strategies as well as malfunctions of selected manifolds and/or turbo/super chargers can be simulated.

The simulation equipment according to the present invention can preferably comprise an embedded hardware-unit (HiL-unit), which operates in real time. By choosing the proper simulation model according to the performance properties of the simulation engine of the equipment, the calculations of the simulation with the inventive simulation method can be processed faster compared to a model where thermodynamic equations are calculated in all cylinders. Therefore on a particular HiL hardware a particular engine can be simulated up to higher engine speeds or an engine with more cylinders and/or more complex intake and/or exhaust systems and/or more turbo/super chargers can be simulated, while still complying with constraints imposed by the HiL.

In a further embodiment the simulation equipment can comprise a hardware unit with multiple cores. In this embodiment different master cylinders and/or different slave cylinders and/or gas path components can be calculated on separate cores. It is, for example, possible to assign one master cylinder and the respective slave cylinders to a single simulation core (if more than one cylinder groups are defined) and/or to assign gas path components to (a) different core(s).

Using the methods and systems according to the invention enables simulation of a multi-cylinder engine:

- in a particular operating regime and on a particular hardware or simulation equipment in shorter computational time (shorter overall computational time of the simulation and also shorter computational time per time step of the gas path domain),

- on a particular HiL hardware up to higher engine speeds, while still complying with constraints imposed by the HiL,

- on a particular HiL hardware with more cylinders and/or more complex intake and/or exhaust systems and/or more turbo/super chargers, while still complying with constraints imposed by the HiL,

- in a particular operating regime and the same computational time on a less performant simulation equipment or hardware.

The invention will further be described in terms of non-restricting examples of preferred embodiments, which are given in connection with the accompanying drawings, wherein

Fig. 1 shows a schematic representation of a simulation model of a multi-cylinder engine according to a 0D modeling approach;

Fig. 2 shows one cylinder block of the simulation model of Fig. 3 in a more detail view; Fig. 3 shows a schematic representation of cylinders in a multi-cylinder engine;

Fig. 4 is a diagram of a cycle resolved engine torque during a load increase;

Fig. 5 shows an enlarged part of the diagram of Fig. 4, illustrating the transient operation;

Fig. 6 shows the diagram of Fig. 4 simulated using a flux correction approach;

Fig. 7 is a diagram showing the mass flow through the intake port plotted against the crank angle of the respective master cylinder; and

Fig. 8 shows a diagram which illustrates the writing to the flux matrix and the mapping step for one slave cylinder.

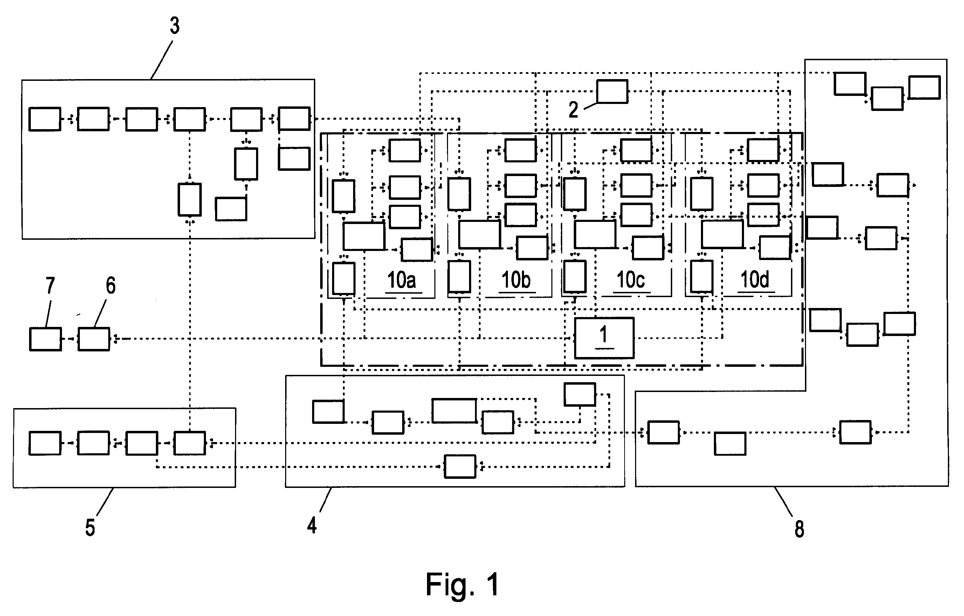

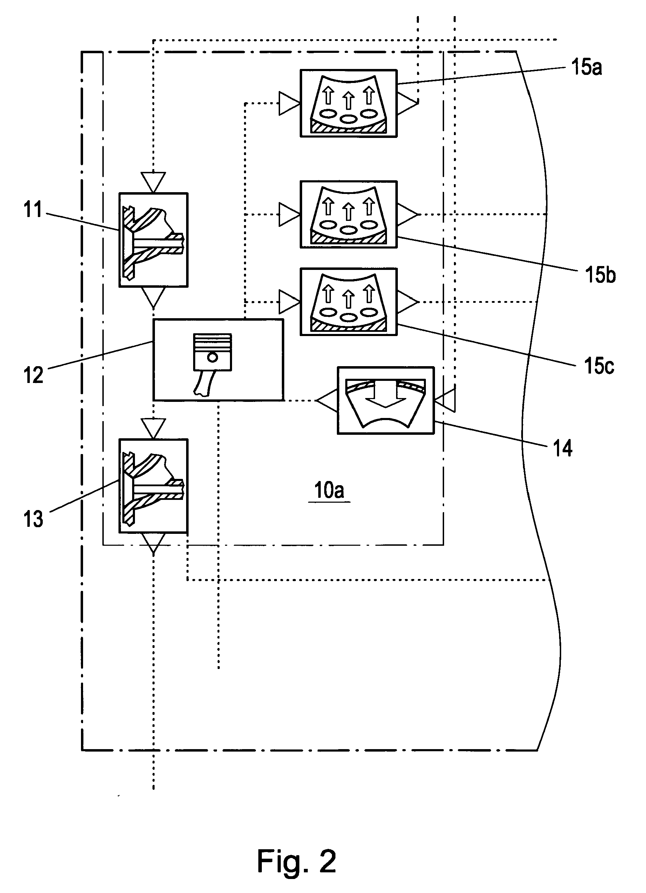

To illustrate the background of the inventive method, Fig. 1 and 2 show basic elements of a physically based simulation of a multi-cylinder engine. In this modeling approach thermodynamic equations are used to model processes in all components. The model presented in Fig. 1 can be grouped to the engine block system 1, a fuel supply system 2, an intake system 3, an exhaust gas system 4, a turbo charger system 5, an engine shaft 6 linked to an exterior mechanical system 7, and a heat transfer model 8. The exterior mechanical system 7 can comprise a simulation of further elements of the power train, such as transmission, drive shafts, differentials, and the final drive of a vehicle. In a multi-cylinder engine, the domain of the engine block further comprises the corresponding number of cylinders as indicated in Fig. 1, wherein engine block 1 comprises four single cylinders 10a, 10b, 10c and 10d. Each cylinder comprises a number of simulation elements.

Fig. 2 shows a more detailed view of the first cylinder 10a of Fig. 1. The simulation elements of cylinder 10a comprise elements for the intake port 11, the combustion chamber 12, the exhaust port 13, the fuel injection 14 and three heat transfer elements 15a, 15b and 15c representing the heat transfer from the combustion chamber to the piston, the liner and the cylinder head, respectively. Indicated work given to the pistons of all cylinders is summarized in the mechanical power unit of the engine block 1, where mechanical losses are modeled and thus effective torque is given to the exterior mechanical system.

All these systems can be modeled using the same integration time step. However the model can be divided into two domains with different characteristic time scales, i.e. the engine block domain, which is characterized by shorter characteristic time scales, and the gas path domain, which is characterized by longer characteristic time scales. In terms of characteristic time scales this domain is denoted as gas path domain as gas components in the gas path are the ones that define the upper level of the applied time steps. The gas path domain of Fig. 1 comprises the fuel supply system 2, the intake system 3, the exhaust gas system 4, the turbo charger system 5, the engine shaft 6, the exterior mechanical system 7, and the heat transfer model 8. The present invention can be applied to modeling approaches where all domains use the same integration time step or to approaches where the engine block domain uses shorter integration time step than the gas path domain.

For reasons of brevity not all systems/elements of the simulation model will be explicitly described in this document, as the structure and operation principle of simulation models are well known to the person skilled in the art, for example from standard simulation tools such as AVL Boost and Cruise, LMS Amesim, a variety of MATLAB Simulink based models or others. During thermodynamic calculation of processes in the combustion chambers of cylinders pressure p, mass m, temperature T and optionally species concentrations $w_i$ in the combustion chamber are calculated. In addition this calculation gives all the fluxes through the transfer elements attached to the combustion chamber (which are shown in Fig. 2). Moreover, the indicated work in the cylinder is calculated by the thermodynamic model. During thermodynamic calculation of processes in combustion chambers of cylinders, the combustion chamber thus exchanges with the intake and exhaust system the mass, enthalpy and optionally species fluxes, through the intake and exhaust ports respectively, with the fuel tank the mass, enthalpy and optionally species fluxes, of the fuel through the fuel injector, with the combustion chamber walls the heat, i.e. enthalpy, fluxes through the heat transfer elements and with the piston the indicated work. If engine block and gas path domains use the same integration time steps the fluxes through the transfer elements attached to the combustion chamber and the indicated work to the pistons are exchanged between the combustion chamber and the elements of the gas path for each time step, whereas if the engine block domain is integrated with smaller time steps, fluxes in the transfer elements attached to the combustion chamber are integrated for a time step of the gas path domain using integration time steps of the engine block domain.

It is obvious that the required computational expenses for the simulation of a model increase with the number of computed simulation systems and with increasing number of elements in the system, and on the other hand the complexity of the calculations required for each element have to be taken into account when assessing the computational expenses. Therefore 0D or even 1 D simulation approaches for real-time simulation are currently constrained to the simulation of only a few cylinders, or even only one cylinder, or simulation of engines with very simple intake and exhaust systems or limited number of turbo/super chargers or the simulation cannot be run up to very high engine speeds.

The present invention is based on a modeling approach wherein one or more master cylinders of multi-cylinder engine are simulated using thermodynamic equations and other slave cylinders and modeled using suitably phased fluxes and indicated work calculated by the corresponding master cylinder. In the context of this document the term "master cylinder" refers to a cylinder wherein processes in the combustion chamber are simulated using thermodynamic equations. The term "slave cylinder" refers to a cylinder wherein processes in the combustion chamber are not simulated using thermodynamic equations, therefore fluxes exchanged through the transfer elements attached to the combustion chamber and the indicated work given to the piston are calculated by suitably shifting the phase of these parameters that were calculated by the corresponding master cylinder.

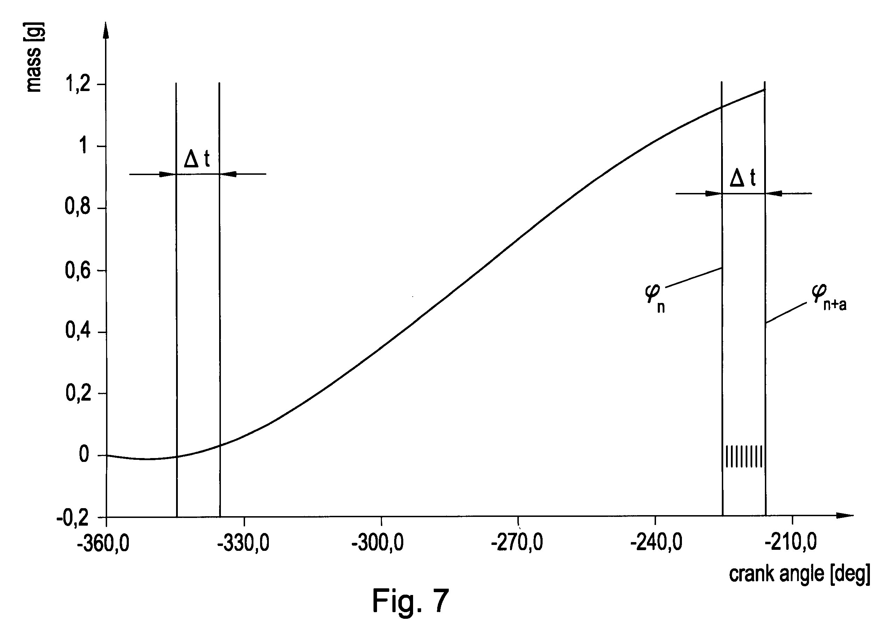

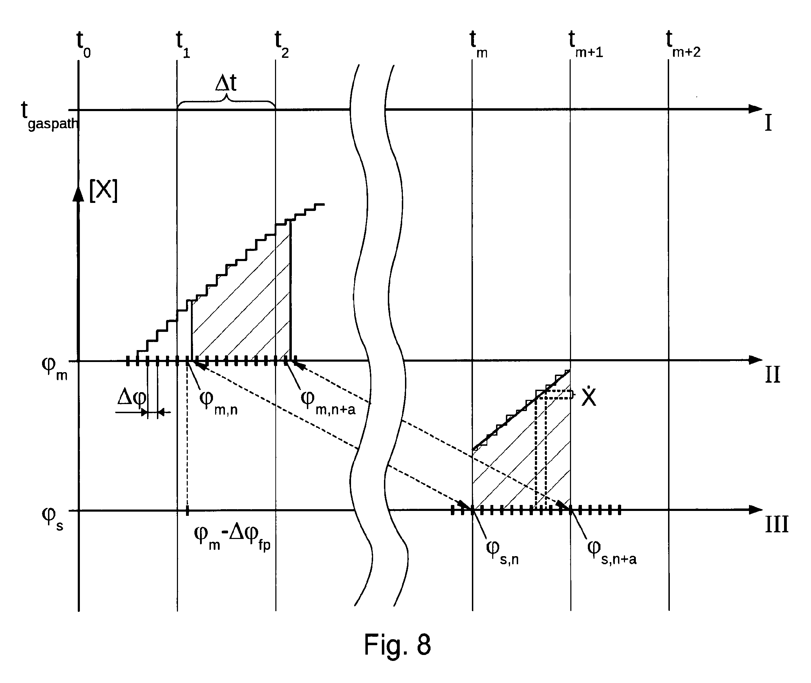

The term "phase shifting", as it is used within this document, denotes a method of determining simulation parameters of one cylinder (slave cylinder) by using the parameters determined for a different cylinder (master cylinder) at a preceding point of time, and taking into account the angular difference between the master cylinder and the slave cylinder imposed by the firing angles of the cylinders (i.e. the different position of the piston at a given time) as indicated in Fig. 7 and 8.

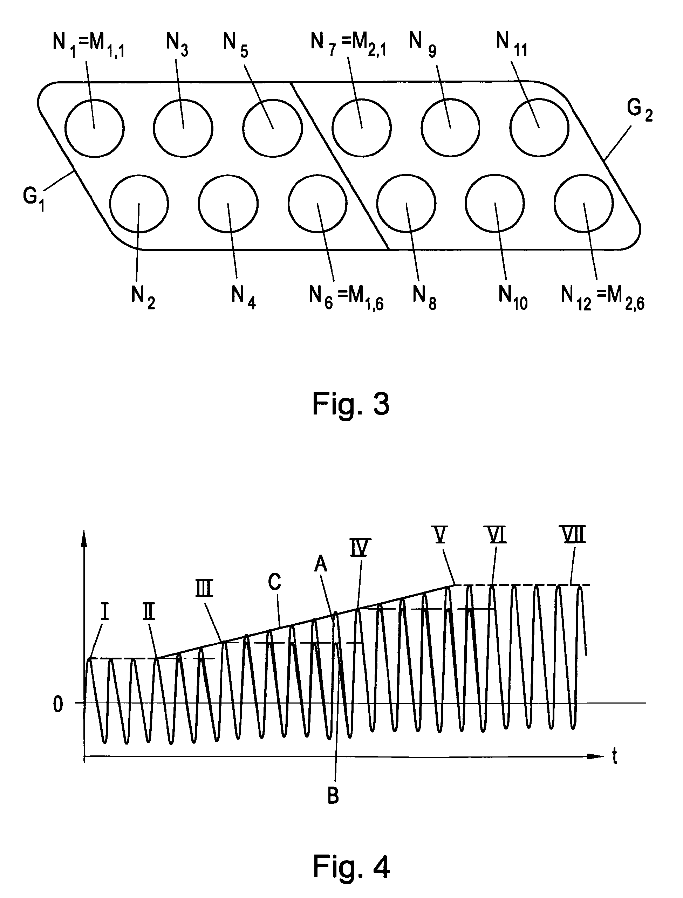

In the following the theoretical background of the invention will be detailed with reference to Fig. 3, which shows a schematic representation of cylinders in a multi-cylinder engine.

Fig. 3 schematically shows the cylinders $N_1$-$N_{12}$ of a combustion engine comprising 12 cylinders. The cylinders are grouped into two cylinder groups $G_1$, $G_2$, each comprising 6 cylinders $M_{1,1}$-$M_{1,6}$ and $M_{2,1}$-$M_{2,6}$, respectively. In each group one cylinder ($M_{1,1}$ in group $G_1$ and $M_{2,1}$ in group $G_2$) is defined as a master cylinder. The Number of cylinders and groups shown in Fig. 3 is merely an example given to facilitate the understanding of the present specification. The grouping of the cylinders according to the invention is not restricted to the shown example. Obviously any different number and grouping of cylinders could be used. In one embodiment all cylinders of an engine belong to a single group.

The configuration exemplified in Fig. 3 could be used for a simulation of the 12-cylinder engine wherein the

cylinders of group $G_2$ use different properties than the cylinders of group $G_1$. For example all cylinders in Group $G_2$ could be deactivated, i.e. not fired, or could share the same turbo charger and different control strategy, or damage of this turbo charger could be simulated while the function of all other cylinders (in this case all cylinders of group G1) remains unaffected, except over engine dynamics that is influenced by the torque produced by the engine.

Not all groups of a simulated engine have to comprise the same number of cylinders, e.g. the first group could comprise 9 cylinders and the second group could comprise 3 cylinders. Any combination of groups could be used for a simulation model as long as each group at least comprises one cylinder (the master cylinder of this group).

If a thermodynamic calculation is used for the simulation according to the invention, pressure p, mass m, temperature t and species concentrations $w_i$ in the combustion chamber or in the other parts of the cylinder model (Fig. 2) are only calculated for the master cylinder (in terms of a thermodynamic calculation). In addition this calculation gives all the fluxes through the attached transfer elements. Moreover, indicated work in the cylinder is calculated by the thermodynamic model.

The simulation procedure for the master cylinder writes integrated values of fluxes through all mass and heat transfer elements and integrated values of the indicted work with the corresponding crank-angle to a "flux matrix" which can be described as

$$
F = \left[ \left[ \begin{array}{c} \varphi \\ \left[ \begin{array}{c} m \\ H \\ W_i \end{array} \right]_{MT_1} \\ \vdots \\ \left[ \begin{array}{c} m \\ H \\ W_i \end{array} \right]_{MT_n} \\ [H]_{HT_1} \\ \vdots \\ [H]_{HT_n} \\ W_{ind} \end{array} \right]_{\varphi=0} \left[ \begin{array}{c} \varphi \\ \left[ \begin{array}{c} m \\ H \\ W_i \end{array} \right]_{MT_1} \\ \vdots \\ \left[ \begin{array}{c} m \\ H \\ W_i \end{array} \right]_{MT_n} \\ [H]_{HT_1} \\ \vdots \\ [H]_{HT_n} \\ W_{ind} \end{array} \right]_{\varphi=\varphi_{stor,1}} \left[ \begin{array}{c} \varphi \\ \left[ \begin{array}{c} m \\ H \\ W_i \end{array} \right]_{MT_1} \\ \vdots \\ \left[ \begin{array}{c} m \\ H \\ W_i \end{array} \right]_{MT_n} \\ [H]_{HT_1} \\ \vdots \\ [H]_{HT_n} \\ W_{ind} \end{array} \right]_{\varphi=\varphi_{stor,2}} \cdots \left[ \begin{array}{c} \varphi \\ \left[ \begin{array}{c} m \\ H \\ W_i \end{array} \right]_{MT_1} \\ \vdots \\ \left[ \begin{array}{c} m \\ H \\ W_i \end{array} \right]_{MT_n} \\ [H]_{HT_1} \\ \vdots \\ [H]_{HT_n} \\ W_{ind} \end{array} \right]_{\varphi=CD} \right] \quad (1)
$$

wherein

$\varphi$ is the crank-angle;
CD is the cycle duration; and
$\varphi_{stor,x}$ are the crank-angles $\varphi$ of the master cylinder used to store the values.

Data should be written to the flux matrix at least every time step of the gas path domain, which is also the case when time steps of engine block and gas path domain are identical, whereas in the case when the time steps of the engine block domain are shorter than the time steps of the gas path domain the frequency of writing the data can be adjusted between the frequency that correspond to the time steps of the engine block and the frequency corresponding to the time steps of the gas path domain. In the latter case, to avoid too frequent writing to the flux vector and thus to reduce the size of the matrix and the associated CPU load, values can be stored if $\varphi_{stor,n+1}\text{-}\varphi_{stor,n}>\Delta\varphi$, where $\Delta\varphi$ is the minimum interval for writing to the flux vector. It is also possible that data are written to the flux matrix at pre-defined values of $\varphi$. Also more complex schemes could be used, for example the length of one angular step could depend on more than one condition, e.g. $\varphi_{stor,n+1}\text{-}\varphi_{stor,n}$ corresponds to an integer number of angular steps within one time step of the gas path domain, with the prerequisite that $\varphi_{stor,n+1}\text{-}\varphi_{stor,n}>\Delta\varphi$.

All values of masses m, enthalpies H, species masses $W_i$ of mass transfer MT and enthalpies H of heat transfer HT represent values of the corresponding fluxes integrated from the start of the cycle until the actual stored crank-angle $\varphi_{stor}$ as

$$
X = \int_0^{\varphi_{stor}} \dot{X} \, d\varphi, \quad (2)
$$

wherein

X denotes the respective simulation output parameter, e.g. m, H or $W_i$; and

$\dot{X}$ denotes the corresponding flow variable in units per degree crank-angle.

Similarly

$$W_{ind} = \int_0^{\varphi_{stor}} p \frac{dV}{d\varphi} d\varphi, \tag{3}$$

represents the integrated value of the indicated work from the start of cycle until the actual stored crank-angle $\varphi_{stor}$.

This procedure is shown for the case of the mass flow through the intake port in Fig. 7. Fig. 7 is a diagram showing the mass flow through the intake port plotted against the crank angle of the respective master cylinder. In this non-restrictive example the engine rotates at a speed of 1500 rpm. Therefore the integration time step $\Delta t$ of the gas path domain of 1 ms corresponds to 9° crank angle and the engine block domain is integrated with steps of 1° crank angle. This exemplifies an approach, wherein the integration increments of the gas path domain are decoupled from the integration increments of the engine block domain, and the first one using time increments and the second one using crank-angle increments. In this example mass flow through the intake port is integrated for 9° crank angle by the engine block domain and afterwards it is being exchanged with the gas path domain. Thereby it is ensured that consistent fluxes are given to the components of the gas path domain at the time steps of the gas path domain. In Fig. 7 the integrated mass flux thought the intake port of a master cylinder is integrated in the considered time step of the gas path domain from -225° up to - 216° crank angle, where -360° crank angle corresponds to the gas exchange top dead center of the four-stroke engine.

To ensure reduced computational load of the multi-cylinder engine model, thermodynamic process are not modeled in the slave cylinders. However, to mimic multi-cylinder engine operation while thermodynamically modeling only one cylinder in each Group $G_g$ (the master cylinder $M_{g,1}$), it is necessary to adequately model the exchange of the fluxes between the slave cylinders and the gas path and engine structure as well as the indicated work produced by the cylinders.

According to the invention this can be done by reading out these values from the "flux matrix" (eq. (1)) and applying them to the slave cylinder (which corresponds to the mapping step).

The crank-angle shifts defined by the firing angle of the slave cylinders have been taken into account, so that every angle referred to in the equations always refers to the respective working cycle position of the cylinder.

For a given interval ($\varphi_n$ to $\varphi_{n+a}$) the mapping can be done by using the formula

$$\dot{X} = \frac{[X]_{\varphi_{n+a}} - [X]_{\varphi_n}}{\varphi_{n+a} - \varphi_n}, \tag{4}$$

wherein

$\varphi_{n+a}$ and $\varphi_n$ represent the respective end and start angles of the simulation time step of the slave cylinder $M_{g,i}$, being mapped from the phase interval of the master cylinder $M_{g,1}$.

In Fig. 8 this mapping procedure is further explained. Fig. 8 shows a Diagram which illustrates the writing to the flux matrix and the mapping step for one slave cylinder. The first ordinate (I) shows the simulation time steps ($t_{gaspath}$= $t_0$, $t_1$, $t_2$...) of the gas path domain, which, in this example correspond to a constant time interval $\Delta t$, which could be, for example, 1 ms. The second ordinate (II) represents the crank angle position $\varphi_m$ of the master cylinder, wherein the simulation of the master cylinder is calculated at an angular basis (i.e. the angular domain of the simulation), so that the simulation output parameter X is calculated at successive angular positions ($\varphi_m = \varphi_0$, $\varphi_1$, $\varphi_2$,....) corresponding to a constant angular interval $\Delta\varphi$. In a practical example $\Delta\varphi$ could be chosen to be 1°, 2° or a different angular value (which can also change during the simulation) suitable for the respective simulation model. The third ordinate (III) represents the crank angle $\varphi_s$ of a slave cylinder, wherein the crank angle positions of the slave cylinder are offset to the respective cylinder positions of the master cylinder by the angular difference of the respective firing angles ($\Delta\varphi_{fp}$). The angular position of the slave cylinder, which is used to read fluxes from the flux matrix generated by the master cylinder, is thus calculated as $\varphi_s = \varphi_m - \Delta\varphi_{fp}$.

To calculate the simulation output parameter X for the slave cylinder in a given time interval $T = t_m, t_{m+1}$, which corresponds to an angular interval $\varphi_s = \varphi_{s,n}, \varphi_{s,n+a}$, the simulation uses the values of the simulation of the master cylinder at the corresponding position $\varphi_m = \varphi_{m,n}, \varphi_{m,n+a}$, that were calculated in one of the previous time steps.

The diagram of Fig. 8 can be compared to Fig. 7 wherein the $\varphi_{n+a}$ and $\varphi_n$ window of 9° crank angle corresponds to one time step of the gas path domain. The flux though the intake port of the slave cylinder that is phased for 120° crank angle according to its master cylinder is calculated by reading the mass values at -345° and -336° crank angle (which have been simulated for the master cylinder and written to the flux matrix at one of the previous time steps) and dividing this value by the crank angle interval i.e. 9° crank angle.

It has to be noted that there are many ways, in which the time and/or angular steps of the engine block domain and the gas path domain can be coupled.

If the domains are fully coupled, both domains are integrated with the same integration step, which can be given in crank-angle or time increments. This approach is applicable to fixed or variable step methods in both crank-angle or time increments.

If the domains of the engine block and the gas path are decoupled, so that they use different time scales, at least one or more integration steps of the engine block domain are performed within one step of the gas path domain. In both domains the integration step can be given in crank-angle or time increments and thus it is also possible to integrate one domain in crank-angle and other in time increments. This approach is applicable to fixed or variable step methods in both crank-angle or time domain. If more than one integration step of the engine block domain is performed within one time step of the gas path domain and if one domain is integrated in in crank-angle and other in time increments, the number of integration steps of the engine block domain in one time step of the gas path domain can change based on the engine speed.

According to the invention the mapping can also use any known interpolation technique to determine a value for any parameter X, Ẋ of the slave cylinder by using the respective stored values [X], [Ẋ] of the master cylinder. For choosing the interpolation technique, the angular intervals, at which the respective values are stored, have to be taken into account. It is pointed out that the storing intervals could also have a varying length, which would also have to be considered. Setting up such interpolation techniques lies within the capabilities of a person skilled in the art.

It is pointed out that eq. (4) is evaluated in the crank-angle and not time domain as this preserves higher level of fidelity in cases with varying engine speed. Nonetheless the invention is not limited to simulations within the crank-angle-domain.

The inventive method described above allows for a simulation performance suitable for carrying out a HiL-Simulation also for modern automotive engines featuring multi-cylinder engines with large number of cylinders and/or engines with complex intake and exhaust system topologies and turbo/super charging topologies operating at high engine speeds, which is not attainable by the current simulation approaches.

The method according to this embodiment is especially useful and accurate in steady state operation of the simulated engine and in slow to moderate transient operating regimes. In steady-state 0D modeling slave cylinders feature the same parameters as the master cylinder of the same dimensions, connected to identical manifolds through equals ports, using equal fuel injectors and connected to equal combustion chamber walls and to the same crankshaft and using the same control strategy, whereas in slow to moderate transient operating regimes these differences are not very pronounced. Nonetheless in fast transient conditions differences can be observed between results of the engine model using slave cylinders and the engine model where these cylinders are modeled by the thermodynamic equations. These differences arise from the fact that all slave cylinders, which are not calculated using a thermodynamic equation but are modeled as phasing images of the master cylinder, feature exactly the same values of all the parameters as the master cylinder. Therefore during transient operation of the multi-cylinder engine, engine torque and all other fluxes exchanged with the engine block do not change gradually over the time but for a particular cylinder group step-wise once in cycle, according to the calculation of the corresponding master cylinder.

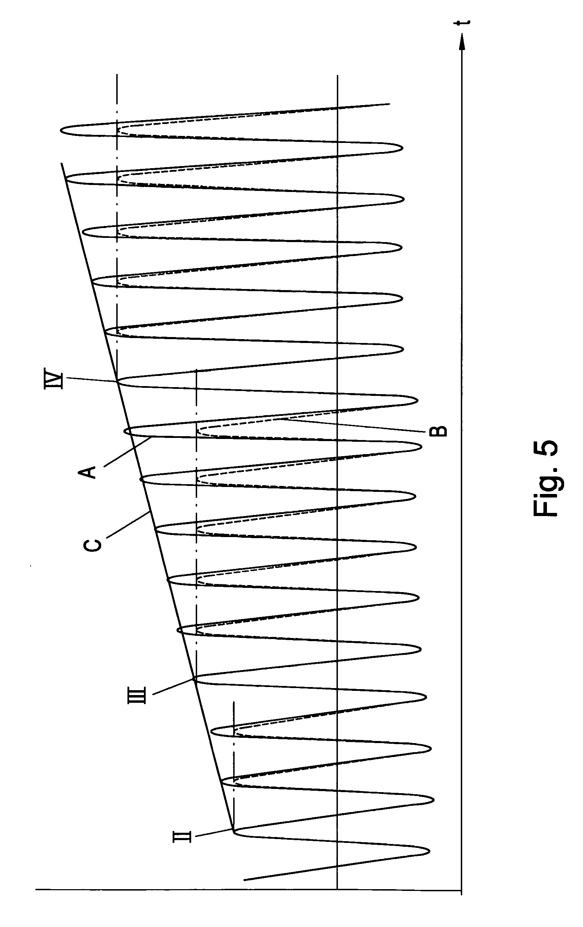

This behavior is demonstrated in Fig. 4 and 5, which show a diagram of the simulated engine torque over time. Fig. 4 shows a complete transient from a first steady state (from point I to point II) to a second steady state (from point V to point VII). The first steady state ends approximately at point II, from where the torque steadily increases up to point V due to increased fuelling at constant engine speed. From point V the torque remains essentially constant at the second steady state. Fig. 4 and 5 represent the torque band of an engine comprising six cylinders. Therefore six consecutive peaks represent one full engine cycle. In Fig. 4 and 5 each first peak of an engine cycle (the peak corresponding to the master cylinder) are the peaks at points I, III, IV and VI.

Curve A, represented by a full line, represents the instantaneous effective torque for a simulation where the thermodynamic process in all cylinders is modeled. It can be seen that during load increase at constant speed of a 6 cylinder engine (from points II to V), the crank-angle resolved torque increases gradually over one engine cycle indicated by III to IV, where torque peaks due to firing of all 6 cylinders are observed.

Curve B, represented by a dashed line in Fig. 5, represents the result for a simulation according to the invention, wherein only one master cylinder is simulated and the simulation parameters of five slave cylinders are determined by mapping without applying correction factors. A comparison between curve A and curve B shows that in steady state operation the results are nearly identical for both simulation approaches. As the load increases between point II and point V (which is indicated by the sloped straight line C), every first peak of a cycle (which represents the calculation of the master cylinder) is followed by five identical torque shapes of the slave cylinders (as is indicated by the cascading dotdashed lines). Therefore the inventive method according to the first aspect enables a significant reduction in computational times for the simulation of the models, however it also leads to lower fidelity of the results during transient engine operation. Reduction in the computational times is dependent on the number of cylinders, complexity of the gas path domain and applied integration time steps in the cylinder and gas path domain, however for 4 and 6 cylinder engines the application of the inventive approach results in approximately 50-65% reduction of the computational time of the complete engine model.

In a further aspect of the invention, the method uses a flux correction technique, which eliminates the cascading torque band while still benefiting from the master/slave-approach. The flux correction technique according to the invention relies on application of thermodynamically derived correction factors to the values read out of the flux vector (eq. (1)) using a reformulated form of eq. (4):

$$\underline{\dot{X}} = C_X \frac{[X]_{\varphi_{n+a}} - [X]_{\varphi_n}}{\varphi_{n+a} - \varphi_n}, \tag{6}$$

wherein $C_X$ represents the correction factor that is used to adapt a specific value $\dot{X}$ of a master cylinder in a way to more adequately reflect actual state of the slave cylinder at the latter time that corresponds to the shift of firing angles (The underscore denotes a corrected simulation output parameter.)

A value of $C_X = 1$ implies that all the slave cylinders feature identical fluxes as the master cylinder in the crank-angle domain. During transient operation of the multi-cylinder engine in general the value will be $C_X \neq 1$, whereas $C_X$ approaches 1 for steady-state engine operation. In the case that $C_X$ is derived from a simulation or control input parameter, or calculated based on the changes of state variables, which have occurred in the time period that corresponds to the shift in firing angles between the master and slave cylinder, a high level of generality and high level of transferability of the flux correction approach can be ensured.

Below a general formulation of the flux correction approach will be described. In general the state in the combustion chamber and thus the fluxes exchanged with the attached transfer elements as well as the indicated work of the cylinder are mostly influenced by the following non-restrictive parameters which can be used as inputs for the flux correction technique:

1. Changed intake manifold pressure

2. Changed intake manifold temperature

3. Changed intake manifold species composition

4. Changed intake manifold density (being the results of 1.-3.)

5. Changed fuelling of the same fuel type, i.e. mass based cyclic fuel delivery

6. For compression ignition engines: Changed fuel injection parameters, i.e. number of injections, starts of injections, durations of injections

7. For spark ignition engines (or other external source ignited engines): spark (or external ignition source) timing

8. Changed fuel blend, i.e. varying ratio between two/multiple fuels

9. Changed intake/exhaust valve timing

10. Changed exhaust manifold pressure

The following list is a non-restrictive example for parameters that can be corrected by the flux correction technique according to the invention:

1. Mass, enthalpy and species flows through the intake port or ports,

2. Mass, enthalpy and species flows through the exhaust port or ports,

3. Mass, enthalpy and species flows through the fuel injector or injectors,

4. Mass, enthalpy and species flows due to any other mean of mass transfer between combustion chamber and adjacent components; this predominantly but not exclusively targets piston rings,

5. Heat flow to the combustion chamber walls, i.e. piston, liner, head or discretized parts of these components; these fluxes can be corrected separately for intake, compression, combustion and expansion as well as for the exhaust stroke,

6. Indicated work performed to the piston; this is corrected separately for intake, compression, combustion and expansion as well as for the exhaust stroke.

Example:

Implementation of the specific flux correction approach

This section comprises a non-limiting illustrative example of a flux correction technique applied to a simulation model. The outlined approach is applicable to four stroke engines. In this section it will be assumed that the firing top dead center (TDC) of each cylinder corresponds to 0 degCA (degree crank-angle) and thus for a four stroke engine gas exchange TDC corresponds to $-CD/2$, i.e. -360 degCA, compression stroke starts according to the piston kinematics at bottom dead center (BDC) and thus at $-CD/4$, i.e. -180 degCA, and expansion stroke starts according to the piston kinematics at subsequent bottom dead center and thus at $CD/4$, i.e. 180 degCA.

This illustrative but not restricting example considers only the dominant correction terms. A person skilled in the art can apply the teachings of this document also to other parameters or for deriving additional correction correlations.

Following these assumptions specific flux correction approaches can be implemented for different parameters as outlined below.

1. Flows through the intake ports:

Determination of correction factors for the flows through the intake ports can be based on the state variation in the intake manifold between the master and the slave cylinder which have occurred in the time period that corresponds to the shift in firing angles between the master and slave cylinder. It is assumed that the volumetric efficiency remains unchanged.

Therefore the correction factors of the flows through the intake ports (intake) are calculated at intake valve opening (IVO), where IVO of the slave (S) and the master (M) cylinder refers to the intake valve opening of the corresponding cylinders and are thus shifted by a difference in the firing angles. During this time shift the state in the intake manifold generally changes leading to the necessity of applying the correction terms. The Flux correction approach of the flows through the intake ports thus yields:

a) Mass flow (m) through the intake port is corrected based on the density variation in the intake manifold:

$$C_{\dot{m},\text{intake}} = \frac{\rho_{\text{IM,S,@IVO}}}{\rho_{\text{IM,M,@IVO}}}, \tag{7}$$

b) Enthalpy flow (H) through the intake port is corrected based on the density and temperature variation in the intake manifold:

$$C_{\dot{H},\text{intake}} = C_{\dot{m},\text{intake}} \frac{T_{\text{IM,S,@IVO}}}{T_{\text{IM,M,@IVO}}}, \tag{8}$$

and

c) Species flows ($\dot{W}$) through the intake port are corrected based on the density and species concentration variation in the intake manifold:

$$C_{\dot{W},\text{intake}} = C_{\dot{m},\text{intake}} \frac{w_{i,\text{IM,S,@IVO}}}{w_{i,\text{IM,M,@IVO}}}, \tag{9}$$

2. Flows through the fuel injectors:

Correction factors for the flows through the fuel injectors can be found based on the load signal variation (LS).

3. Indicated work:

Correction factors for the indicated work can be determined according to the following scheme:

    a) Indicated work in the intake stroke (INT) based on the pressure variation in the intake manifold

    b) Indicated work in the compression stroke (COMP) based on the pressure variation in the intake manifold

    c) Indicated work in the expansion stroke (EXP) based on the assumption of unchanged high pressure cycle (compression + expansion) indicated efficiency ($n_{ind,HP}$) between the master and the slave cylinder and variation in injected fuel quantity between the master and the slave cylinder

    d) Indicated work in the exhaust stroke (EXH) based on the pressure variation in the exhaust manifold

4. Heat flows:

Correction factors for the heat flows to the combustion chamber walls can be determined according to the following scheme:

    a) Heat flow in the intake stroke (INT) based on the temperature variation in the intake manifold

    b) Heat flow in the compression stroke (COMP) based on the temperature variation in the intake manifold

    c) Heat flow in the expansion stroke (EXP) based on the overall energy balance in the combustion chamber over the entire cycle, i.e. energy balance of the incoming enthalpy flows through the intake ports and the injected fuel, heat transferred to the combustion chamber walls, work performed to the piston and enthalpy flows thorough the exhaust ports

    d) Heat flow in the exhaust stroke (EXH) as in 4.c)

5. Flows through the exhaust ports:

Correction factors for the flows through the exhaust ports can be determined according to the following scheme:

    a) Mass flow (m) through the exhaust port is corrected based on the correction of the mass flow through the intake port (1.a)) and the mass of injected fuel (2.)

    b) Enthalpy flow ($\dot{H}$) through the exhaust port is corrected as in 4.c)

    c) Species flows ($\dot{W}$) through the exhaust port are corrected based on the correction of the species flows through the intake port (1.c)) and the mass of injected fuel (2.).

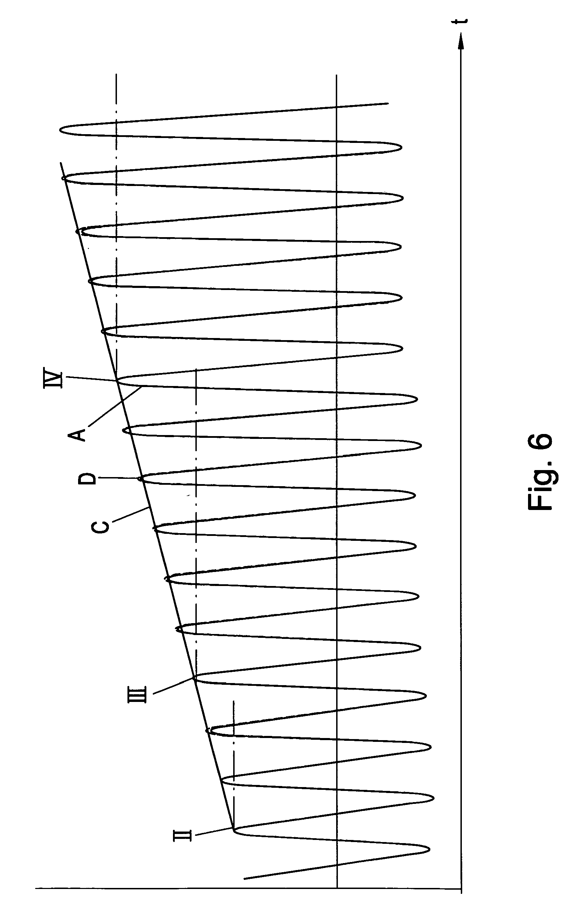

Results calculated by a model applying one master and five slave cylinders and additional use of the proposed flux correction technique are shown in Fig. 6, which represents a simulated torque during transient engine operation. Curve A, represented by a full line, represents the instantaneous effective torque for a simulation where the thermodynamic process in all cylinders is modeled and curve D, represented by a dashed line, represents the result for a simulation according to the invention using the flux correction according to the Example described above. It can be seen that curve D closely follows curve A, which demonstrates that much more adequate transient results of the slave cylinders can be achieved by using the flux correction technique. It can be seen that the cascading steps of curve B in Fig. 5 can be avoided by applying the flux correction. This approach thus offers benefit in computational speed due to calculation of only one master cylinder, whereas it enables predicting much more accurate transient results. Fig. 6 shows only results of the torque trace, whereas flux correction is applied also to all the flows through the mass and the heat transfer elements as outlined above. As flux correction is based on analytic formulas with very low CPU demand, there is no observable difference in the computational time of the model if flux correction is applied or not.

**Claims**

1. Method for simulation of an internal combustion engine comprising a number ($cyl_{total}$) of cylinders ($N_{cyl}$), wherein simulation output parameters ($X$, $\dot{X}$) of the cylinders ($N_{cyl}$) are calculated based on the angular position ($\varphi_{cs}$) of a crank shaft and wherein the method is **characterized by** the following steps:

   - grouping the cylinders ($N_{cyl}$) into a number ($g_{total}$) of cylinder groups ($G_g$), wherein each cylinder group ($G_g$) comprises a number ($i_{total}$) of cylinders ($M_{g,i}$), with a minimum of one cylinder;
   - designating one cylinder ($M_{g,1}$) of each group as a master cylinder and all other cylinders ($M_{g,i}$) in the same group as slave cylinders; and
   - for each simulation timestep

      ○ calculating simulation output parameters ($X$, $\dot{X}$) of the master cylinder for at least one crank-angle position ($\varphi_{stor,x}$) within the respective simulation step by simulation of the master cylinder ($M_{g,1}$) and storing the output parameters; and
      ○ determining simulation output parameters of the slave cylinders ($M_{g,i}$) at the current angular position ($\varphi_{g,i}$) of the respective slave cylinder by mapping of previous simulation output parameters ($[X],[\dot{X}]$), which were stored for the master cylinder ($M_{g,1}$) at at least one previous simulation step of the master cylinder.

2. Method according to claim 1, wherein the intervals $\Delta t$ of the simulation timesteps are calculated in a time domain and intervals $\Delta\varphi$ of the crank-angle positions ($\varphi_{stor,x}$) are calculated in an angular domain.

3. Method according to claim 2, wherein the mapping uses linear interpolation between previous simulation output parameters ($[X]_{n-a}$, $[X]_{n-a}$, $[X]_n$, $[X]_n$) stored at an angular interval ($\varphi_n$ to $\varphi_{n+a}$).

4. Method according to claim 1, 2 or 3, which additionally comprises the steps of

   - determining a correction factor (C) for a simulation output parameter ($X$, $\dot{X}$) for the current angular position ($\varphi_{g,i}$) of the slave cylinder;
   - applying the correction factor (C) to a mapped simulation output parameter of the slave cylinder for the current angular position ($\varphi_{g,i}$).

5. Method according to claim 4, wherein a correction factor (C) is derived from a simulation or control input parameter, or calculated based on the changes of state variables.

6. Method according to claim 5, wherein the correction factor (C) is calculated based on state changes which have occurred in the time period between the time of the simulation step of the stored previous output parameters and the time of the actual simulation step.

7. Method according to any of the claims 1 to 6, wherein the simulation of the master cylinder is performed based on a physical based modeling approach.

8. Method according to any of the claims 1 to 7, wherein the number ($g_{total}$) of groups is one.

9. Method according to any of the claims 1 to 8, wherein the number ($g_{total}$) of groups is larger than one.

10. Method according to any of the claims 1 to 9, wherein the cylinders ($M_{g,i}$) of at least one group ($G_g$) are associated to a common intake and/or exhaust manifold and/or a common turbo/super charger and/or to a common control strategy.

11. Simulation equipment comprising a simulation engine comprising means to perform a method according to any of the claims 1 to 10.

12. Simulation equipment according to claim 11, further comprising an embedded hardware-unit, which operates in real time.

13. Simulation equipment according to claim 11 or 12, comprising a hardware unit with multiple cores.

**Patentansprüche**

1. Verfahren zur Simulation eines Verbrennungsmotors, der eine Anzahl ($cyl_{total}$) von Zylindern ($N_{cyl}$) umfasst, wobei Ausgangsparameter ($X$, $\dot{X}$) der Simulation der Zylinder ($N_{cyl}$) anhand der Winkellage ($\varphi cs$) einer Kurbelwelle berechnet werden, und wobei das Verfahren durch folgende Schritte gekennzeichnet ist:

   - Gruppierung der Zylinder ($N_{cyl}$) in eine Anzahl ($g_{total}$) von Zylindergruppen ($G_g$), wobei jede Zylindergruppe ($G_g$) eine Anzahl ($i_{total}$) von Zylindern ($M_{g,i}$) umfasst, mit mindestens einem Zylinder;
   - Bestimmung eines Zylinders ($M_{g,1}$) jeder Gruppe als Geberzylinder und aller anderen Zylinder ($M_{g,i}$) in derselben Gruppe als Nehmerzylinder; und
   - für jeden Simulationszeitschritt

     ◦ Berechnen der Ausgangsparameter ($X$, $\dot{X}$) der Simulation des Geberzylinders für mindestens eine Kurbelwinkellage ($\varphi_{stor,x}$) innerhalb des entsprechenden Simulationsschrittes durch Simulation des Geberzylinders ($M_{g,1}$) und Speicherung der Ausgangsparameter; und
     ◦ Festlegen der Ausgangsparameter der Simulation der Nehmerzylinder ($M_{g,i}$) in der aktuellen Winkellage ($\varphi_{g,i}$) des entsprechenden Nehmerzylinders durch Zuordnung der vorherigen Ausgangsparameter ($[X]$, $[\dot{X}]$) der Simulation, die für den Geberzylinder ($M_{g,1}$) bei mindestens einem vorherigen Simulationsschritt des Geberzylinders gespeichert wurden.

2. Verfahren nach Anspruch 1, wobei die Intervalle $\Delta t$ der Simulationszeitschritte in einer Zeitdomäne berechnet werden und Intervalle $\Delta\varphi$ der Kurbelwinkellagen ($\varphi_{stor,x}$) in einem Winkelbereich berechnet werden.

3. Verfahren nach Anspruch 2, wobei die Zuordnung lineare Interpolation zwischen vorherigen Ausgangsparametern ($[X]_{n-a}$, $[\dot{X}]_{n-a}$, $[X]_n$, $[\dot{X}]_n$) der Simulation nutzt, die in einer Winkeldomänel ($\varphi_n$ bis $\varphi_{n+a}$) gespeichert sind.

4. Verfahren nach Anspruch 1, 2 oder 3, das zusätzlich folgende Schritte umfasst:

   - Ermitteln eines Korrekturfaktors ($C$) für einen Ausgangsparameter der Simulation ($X$, $\dot{X}$) für die aktuelle Winkellage ($\varphi_{g,i}$) des Nehmerzylinders;
   - Anwenden des Korrekturfaktors ($C$) an einen zugeordneten Ausgangsparameter der Simulation des Nehmerzylinders für die aktuelle Winkellage ($\varphi_{g,i}$).

5. Verfahren nach Anspruch 4, wobei ein Korrekturfaktor ($C$) von einem Eingangsparameter der Simulation oder der Steuerung abgeleitet wird oder anhand der Änderungen von Zustandsgrößen berechnet wird.

6. Verfahren nach Anspruch 5, wobei der Korrekturfaktor ($C$) anhand von Zustandsänderungen berechnet wird, die in dem Zeitraum zwischen der Zeit des Simulationsschrittes der gespeicherten vorherigen Ausgangsparameter und der Zeit des tatsächlichen Simulationsschrittes stattgefunden haben.

7. Verfahren nach einem der Ansprüche 1 bis 6, wobei die Simulation des Geberzylinders anhand eines physikalisch basierten Modellierungsansatz vorgenommen wird.

8. Verfahren nach einem der Ansprüche 1 bis 7, wobei die Anzahl ($g_{total}$) von Gruppen eins ist.

9. Verfahren nach einem der Ansprüche 1 bis 8, wobei die Anzahl ($g_{total}$) von Gruppen größer als eins ist.

10. Verfahren nach einem der Ansprüche 1 bis 9, wobei die Zylinder ($M_{g,i}$) von mindestens einer Gruppe ($G_g$) einem gemeinsamen Ansaug- und / oder Abgaskrümmer und / oder einem gemeinsamen Turbolader /Superlader und / oder einr gemeinsamen Regelstrategie zugeordnet sind.

11. Simulationsanlage, die einen Simulationsmotor umfasst, der Mittel umfasst um ein Verfahren gemäß einem der Ansprüche 1 bis 10 durchzuführen.

12. Simulationsanlage nach Anspruch 11, weiterhin umfassend eine integrierte Hardware, die in Echtzeit läuft

13. Simulationsanlage nach Anspruch 11 oder 12, die eine Hardware mit mehreren Kernen umfasst.

**Revendications**

1. Procédé de simulation d'un moteur à combustion interne comprenant un nombre ($cyl_{total}$) de cylindres ($N_{cyl}$) , les paramètres de sortie de simulation (X, Ẋ) des cylindres ($N_{cyl}$) étant calculés en fonction de la position angulaire ($\varphi_{cs}$) d'un vilebrequin et le procédé étant **caractérisé par** les étapes suivantes consistant à :

   - grouper les cylindres ($N_{cyl}$) en un nombre ($g_{total}$) de groupes de cylindres ($G_g$), chaque groupe de cylindres ($G_g$) comportant un nombre ($i_{total}$) de cylindres ($M_{g,i}$), avec un minimum d'un cylindre ;
   - désigner un cylindre ($M_{g,1}$) de chaque groupe comme maître-cylindre et tous les autres cylindres ($M_{g,i}$) du même groupe comme cylindres esclaves ; et
   - à chaque incrément de temps de simulation

     ◦ calculer les paramètres de sortie de simulation (X, Ẋ) du maître-cylindre pour au moins une position d'angle de vilebrequin ($\varphi_{stor,x}$) à l'intérieur de l'étape de simulation respective par simulation du maître-cylindre ($M_{g,1}$) et mémoriser les paramètres de sortie ; et
     ◦ déterminer DE paramètres de sortie de simulation des cylindres esclaves ($M_{g,i}$) à la position angulaire actuelle ($\varphi_{g,i}$) du cylindre esclave respectif par mappage de paramètres de sortie de simulation précédents ([X], [Ẋ]), qui ont été mémorisés pour le maître-cylindre ($M_{g,1}$) à au moins une étape de simulation préalable du maître-cylindre.

2. Procédé selon la revendication 1, dans lequel les intervalles $\Delta t$ des incréments de simulation sont calculés dans un domaine temporel et les intervalles $\Delta\varphi$ des positions d'angle de vilebrequin (($\varphi_{stor,x}$) sont calculés dans un domaine angulaire.

3. Procédé selon la revendication 2, dans lequel le mappage utilise une interpolation linéaire entre les paramètres de sortie de simulation précédents ([X]$_{n-a}$, [Ẋ]$_{n-a}$, [X]$_n$, [X]$_n$) mémorisé à un intervalle angulaire ($\varphi_n$ à $\varphi_{n+a}$).

4. Procédé selon la revendication 1, 2 ou 3, qui comprend en outre les étapes consistant à

   - déterminer un facteur de correction (C) pour un paramètre de sortie de simulation (X, Ẋ) pour la position angulaire actuelle ($\varphi_{g,i}$) du cylindre esclave ;
   - appliquer le facteur de correction (C) à un paramètre de sortie de simulation mappé du cylindre esclave pour la position angulaire actuelle ($\varphi_{g,i}$).

5. Procédé selon la revendication 4, dans lequel un facteur de correction (C) est dérivé d'un paramètre d'entrée de commande ou de simulation ou calculé en fonction des changements de variables d'état.

6. Procédé selon la revendication 5, dans lequel le facteur de correction (C) est calculé sur la base de changements d'état qui se sont produits pendant la période de temps entre le moment de l'étape de simulation des paramètres de sortie précédents mémorisés et l'étape de simulation réelle.

7. Procédé selon l'une quelconque des revendications 1 à 6, dans lequel la simulation du maître-cylindre est réalisée sur la base d'une approche de modélisation physique.

8. Procédé selon l'une quelconque des revendications 1 à 7, dans lequel le nombre ($g_{total}$) de groupes est un.

9. Procédé selon l'une quelconque des revendications 1 à 8, dans lequel le nombre ($g_{total}$) de groupes est supérieur à un.

10. Procédé selon l'une des revendications 1 à 9, dans lequel les cylindres ($M_{g,i}$) d'au moins un groupe ($G_g$) sont associés à un collecteur d'admission et/ou d'échappement et/ou à un compresseur/turbocompresseur à suralimentation commun et/ou à une stratégie de commande commune.

11. Équipement de simulation comprenant un moteur de simulation équipé de moyens pour mettre en oeuvre un procédé selon l'une quelconque des revendications 1 à 10.

12. Équipement de simulation selon la revendication 11, comprenant en outre une unité matérielle embarquée qui fonctionne en temps réel.

**13.** Équipement de simulation selon la revendication 11 ou 12, comprenant une unité matérielle à noyaux multiples.

Fig. 1

EP 2 949 908 B1

15a

11

15b

12

15c

14

13

10a

Fig. 2

$N_1 = M_{1,1}$   $N_3$   $N_5$   $N_7 = M_{2,1}$   $N_9$   $N_{11}$

$G_1$

$G_2$

$N_2$   $N_4$   $N_6 = M_{1,6}$   $N_8$   $N_{10}$   $N_{12} = M_{2,6}$

Fig. 3

Fig. 4

Fig. 5

EP 2 949 908 B1

Fig. 6

EP 2 949 908 B1

Fig. 7

EP 2 949 908 B1

Fig. 8

I

II

III

$t_{m+2}$  $t_{m+1}$  $t_m$  $t_2$  $t_1$  $t_0$

$t_{gaspath}$

$[X]$

$\varphi_m$

$\varphi_s$

$\Delta t$

$\Delta \varphi$

$\dot{X}$

$\varphi_{s,n+a}$

$\varphi_{s,n}$

$\varphi_{m,n+a}$

$\varphi_{m,n}$

$\varphi_m - \Delta\varphi_{fp}$

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2579115 B1
- US 2013090886 A1
- WO 2008078097 A1
- US 2011083642 A1

**Non-patent literature cited in the description**

- **KATRASNIK, T. et al.** Tailored cylinder models for system level engine modelling. *IFAC Workshop on Engine and Powertrain Control, Simulation and Modeling,* 2012, vol. 3 (1), 162-169